# EUROPEAN PATENT APPLICATION

(11) **EP 2 444 753 A2**
(43) Date of publication of application: **25.04.2012**
(21) Application number: 11186450.0
(22) Date of filing: 25.10.2011
(51) Int. Cl.: F24F 11/00, H05K 7/20

(54) **Air-conditioning system**

(30) Priority: 25.10.2010 JP 2010239102
(71) Applicant: Fujitsu Limited, Kawasaki-shi, Kanagawa 211-8588 (JP)
(72) Inventor: Ishimine, Junichi, Kanagawa 211-8588 (JP); Ohba, Yuji, Kanagawa 211-8588 (JP); Haneda, Tomoaki, Kanagawa 211-8588 (JP); Takeda, Jun, Kanagawa 211-8588 (JP); Iwasaki, Masamichi, Kanagawa 210-9530 (JP); Mizumura, Shinji, Kanagawa 210-9530 (JP)
(74) Representative: HOFFMANN EITLE

(57) **Abstract**

An air-conditioning system includes a ceiling plenum disposed above a ceiling of a room; an air-conditioning machine disposed in an internal space of the room; a plurality of IT apparatus mounting racks disposed in a plurality of rows, with rear faces of the IT apparatus mounting racks in adjacent two rows opposed to each other; a upper partitioning board disposed between an upper face of the plurality of IT apparatus mounting racks and the ceiling; an end-partitioning board disposed between each of ends of a space between adjacent two rows of the plurality of IT apparatus mounting racks and the ceiling; and a ceiling opening portion provided in the ceiling above a warm-air space enclosed by the upper partitioning board and the end-partitioning board. The ceiling opening portion connects the warm-air space with the ceiling plenum.

## Description

### FIELD

Embodiments discussed herein are related to an air-conditioning system used in a computer room and the like.

### BACKGROUND

IT (information technology) apparatuses used in offices, such as servers, storage systems, and network apparatuses, are often installed in a computer room, which may be hereafter referred to as a "data center", a "machine room", or a "server room". The IT apparatuses such as servers, storage systems, and network apparatuses are usually housed in an IT apparatus mounting rack. For example, in a data center, plural IT apparatus mounting racks are arranged in order.

An IT apparatus typically includes a CPU and other functional components, which generate heat by consuming power during operation. Thus, in order to ensure normal operation of the IT apparatus or its operational reliability, the functional components need to be maintained at a certain temperature or below. For this purpose, an IT apparatus generally includes an airflow generating component such as a fan in order to forcibly cool the internal functional components.

Specifically, the IT apparatus is designed to suction air of a certain temperature or below via an air inlet, and an upper-limit temperature of the suctioned air is predetermined as an operation-guaranteeing temperature. At the data center, typically a number of IT apparatuses are installed within a certain space (or room). Thus, the temperature of the air in the space (or room) may become excessively high due to the heat generated by the IT apparatuses unless the temperature is controlled by air-conditioning. Accordingly, at data centers, an air-conditioning system is generally provided in a common space (or room) or in a separate space (or room) in order to prevent the air temperature from exceeding the operation-guaranteeing temperature of the IT apparatuses. The air-conditioning system dissipates the heat emitted in the IT-apparatus installed area to the outside of the IT-apparatus installed area, such as outside the building of the data center. In this way, the temperature in the room (or space) in which the IT apparatuses are installed is maintained at a certain temperature or below.

The air-conditioning system may be configured to dissipate the heat to the outside while circulating the air in the data center. Specifically, the relatively low-temperature air discharged from an air-conditioning machine of the air-conditioning system is supplied to an air inlet of the IT apparatus mounting rack. The relatively low-temperature air is then caused to enter an IT apparatus by the airflow generating component built inside the IT apparatus, such as a fan. In this way, the CPU or other functional components in the IT apparatus are cooled. The air that is heated to a relatively high temperature by collecting heat from the functional components in the IT apparatus is then discharged via an exhaust outlet of the IT apparatus. The discharged air is quickly returned back to the air inlet of the air-conditioning system and taken into the air-conditioning machine. In the air-conditioning machine, heat is dissipated from the air, thereby producing low-temperature air which is again blown out of the air-conditioning machine.

Generally, a number of IT apparatus mounting racks are arranged in order in the data center or computer room. Under the floor of the data center, a space is provided in which the low-temperature air exiting from the air-conditioning machine flows. Such a space may be hereafter referred to as an "underfloor plenum". An opening portion is provided in the floor of the computer room in order to let the low-temperature air flow out of the underfloor plenum up onto the floor. The opening is provided near the air inlet of each of the IT apparatus mounting racks installed on the floor, so that the low-temperature air that has flowed out of the opening up onto the floor can be suctioned into the IT apparatus mounting rack.

The air inlet of the IT apparatus mounting rack is typically provided in a front face of the IT apparatus mounting rack. The air suctioned via the air inlet is further suctioned into the IT apparatus on the IT apparatus mounting rack and then discharged out into the IT apparatus mounting rack after cooling the inside of the IT apparatus. The air discharged out of the IT apparatus into the IT apparatus mounting rack is warmed because of the heat absorbed from the internal components of the IT apparatus. The warmed air in the IT apparatus mounting rack is then discharged via an air exhaust outlet provided in a back surface of the IT apparatus mounting rack into the computer room. The warmed air then flows upward, moves laterally along the ceiling of the computer room, and then is suctioned into the air-conditioning machine. After having been cooled by the air-conditioning machine, the air is again blown out of the air-conditioning machine into the underfloor space as low-temperature air.

In the above air-conditioning system, the low-temperature air that has been sent onto the floor via the opening of the computer room floor is suctioned into the air inlet provided in the front face of the IT apparatus mounting rack. However, not all of the low-temperature air is suctioned into the air inlet. Some of the low-temperature air may keep flowing in the computer room and become mixed with warm air, which is then suctioned into the air-conditioning machine. In this case, the low-temperature air that has not been suctioned into the IT apparatus mounting rack is not used for cooling the IT apparatus. Thus, the cooling efficiency of the air-conditioning system is lowered.

Further, the air suctioned via the air inlet in the front face of the IT apparatus mounting rack includes not only the low-temperature air flowing out of the opening in the floor but also the relatively high-temperature air of the computer room that is present near the air inlet. Thus, the temperature of the air suctioned into the IT apparatus mounting rack is increased, resulting in a decrease in cooling efficiency of the air-conditioning system.

Thus, in order to prevent the decrease in cooling efficiency, it has been proposed to separate the space in which the low-temperature air coming out of the opening portion of the floor flows from the space in which the warm air discharged from the IT apparatus mounting racks flows, by providing a separating plate in the computer room (see Japanese Laid-open Patent Publications No. 2004-184070 and No. 2009-36490, for example).

In a structure generally used for separating the space ("cool-air space") in which the low-temperature air flows and the space ("warm-air space") in which the warm air flows by the separating plate, the cool-air space is separated from the space of the computer room. For example, in one proposal, two rows of IT apparatus mounting racks are installed on the computer room floor such that the front faces of the mounting racks are opposed to each other. An opening portion is provided in the floor between the two rows of the IT apparatus mounting racks, and separating plates are installed to enclose the space between the two rows of the IT apparatus mounting racks, thus separating the cool-air space. The space (cool-air space) between the two rows of the IT apparatus mounting racks may generally be used as an aisle referred to as a "cold aisle". By thus separating the cool-air space, only the low-temperature air flowing out of the opening portion of the floor can be allowed to be suctioned into the IT apparatus mounting racks, so that the low-temperature air can be exclusively introduced into the IT apparatus mounting racks efficiently.

However, in the above structure for separating the cool-air space, when the IT apparatuses mounted in the IT apparatus mounting rack require a large flow of air, the flow rate (volume of supplied air) of the low-temperature air supplied via the opening portion of the floor may be smaller than the air volume (required air volume) required by the IT apparatuses mounted in the IT apparatus mounting rack. In this case, the air pressure within the cool-air space may become lower than the air pressure of the surrounding space (high-temperature space). As a result, warm air may flow into the cool-air space via a slight gap in the separating plates or a gap within the IT apparatus mounting rack. Consequently, the warm air may become mixed with the air suctioned into the IT apparatus mounting rack, thereby lowering the cooling efficiency.

However, completely separating the cool-air space without any gaps is difficult due to cost. Further, various types of IT apparatuses may be mounted in the IT apparatus mounting rack, so that various amounts of air may need to be supplied to different cool-air spaces. Accordingly, it is difficult to supply cool air to the multiple cool-air spaces as required from an air-conditioning machine installed around the IT apparatus mounting rack.

### SUMMARY

In view of the foregoing, it is an object in one aspect of the invention to provide an air-conditioning system capable of introducing low-temperature air efficiently into the IT apparatus mounting racks and supplying a required amount of low-temperature air to each of the IT apparatus mounting racks.

According to an aspect of the invention, an air-conditioning system includes a ceiling plenum disposed above a ceiling of a room; an air-conditioning machine disposed in an internal space of the room; a plurality of IT apparatus mounting racks disposed in a plurality of rows, with rear faces of the IT apparatus mounting racks in adjacent two rows opposed to each other; a upper partitioning board disposed between an upper face of the plurality of IT apparatus mounting racks and the ceiling; an end-partitioning board disposed between an end of a space between adjacent two rows of the plurality of IT apparatus mounting racks and the ceiling; and a ceiling opening portion provided in the ceiling above a warm-air space enclosed by the upper partitioning board and the end-partitioning board. The ceiling opening portion connects the warm-air space with the ceiling plenum.

### BRIEF DESCRIPTION OF DRAWINGS

FIG. 1 is a schematic cross-section of an example of an IT apparatus mounting rack;
FIG. 2 illustrates the inside of a data center in which an air-conditioning system according to Embodiment 1 is installed;
FIG. 3 is a plan view of a part of a room in which the IT apparatus mounting racks are installed, as seen from the ceiling side;
FIG. 4 schematically illustrates a part of a data center in which the air-conditioning system according to Embodiment 1 including a local air-conditioning machine is installed;
FIG. 5 schematically illustrates a structure of the local air-conditioning machine according to Embodiment 1;
FIG. 6 is a schematic cross-section of an IT apparatus mounting rack including an opening portion provided in an upper face;
FIG. 7 schematically illustrates the inside of a data center in which an air-conditioning system according to Embodiment 2 is installed;
FIG. 8 schematically illustrates a part of a data center in which the air-conditioning system according to Embodiment 2 including a local air-conditioning machine is installed; and
FIG. 9 schematically illustrates a structure of the local air-conditioning machine according to Embodiment 2.

### DESCRIPTION OF EMBODIMENTS

Preferred embodiments will be explained with reference to the accompanying drawings.

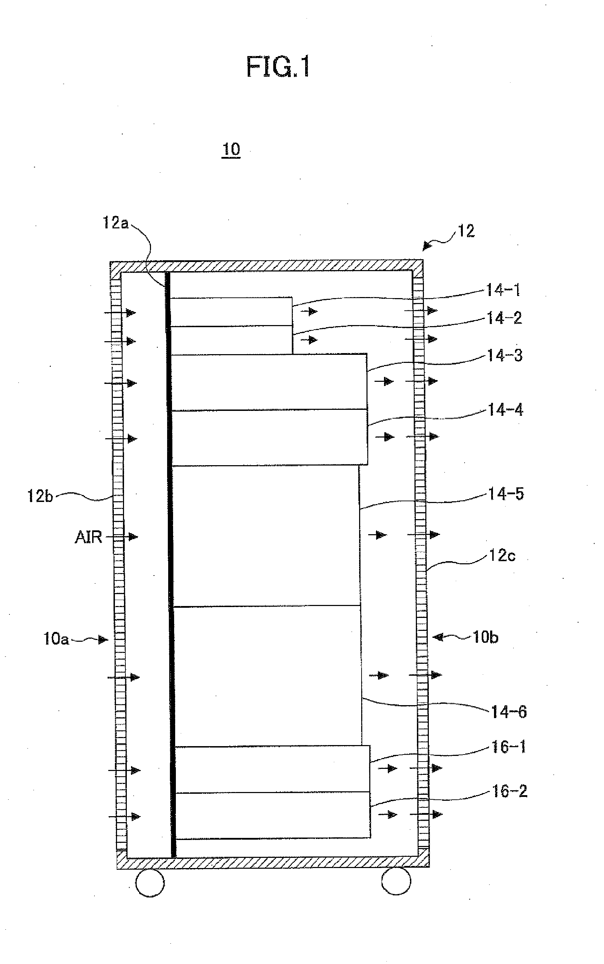

An IT apparatus mounting rack 10 for housing a plurality of IT apparatuses will be described. FIG. 1 is a schematic cross-section of the IT apparatus mounting rack 10. The IT apparatus mounting rack 10 includes a box-shaped enclosure 12 with a front face 10a that can be opened and closed. In the enclosure 12, there are provided shelves on which IT apparatuses 14-1 through 14-6 and power supply units 16-1 and 16-2 are mounted one above another. Each of the IT apparatuses 14-1 through 14-6 and the power supply units 16-1 and 16-2 includes a cooling fan. The cooling fan suctions air from a front face side of the apparatus, cools the internal parts with the air, and then discharges the air from a rear face side of the apparatus.

An intra-rack intake/discharge partitioning board 12a is provided in the enclosure 12 at a position closer to the front face 10a of the IT apparatus mounting rack 10. The IT apparatuses 14-1 through 14-6 and power supply units 16-1 and 16-2 are housed in the enclosure 12 with their front faces surrounded by the intra-rack intake/discharge partitioning board 12a. Specifically, the space in the enclosure 12 is separated into a front side and a rear side by the front faces of the IT apparatuses 14-1 through 14-6 and power supply units 16-1 and 16-2 and the intra-rack intake/discharge partitioning board 12a. Thus, the IT apparatuses 14-1 through 14-6 and power supply units 16-1 and 16-2 suction or collect air from the front side of the intra-rack intake/discharge partitioning board 12a and then discharge the air toward the rear side of the intra-rack intake/discharge partitioning board 12a. Because the space within the enclosure 12 is separated by the intra-rack intake/discharge partitioning board 12a, air does not easily flow from the rear side toward the front side of the intra-rack intake/discharge partitioning board 12a.

The front face 10a of the IT apparatus mounting rack 10 (corresponding to the front face of the enclosure 12) includes a front opening portion 12b. Air can be introduced from outside the front face 10a into the enclosure 12 via the front opening portion 12b. On the other hand, in a rear face 10b of the IT apparatus mounting rack 10 (corresponding to the rear face of the enclosure 12), there is provided a rack-rear-face opening portion 12c. The air discharged to the rear side of the intra-rack intake/discharge partitioning board 12a can be discharged to the outside of the rear face 10b via the rack-rear-face opening portion 12c.

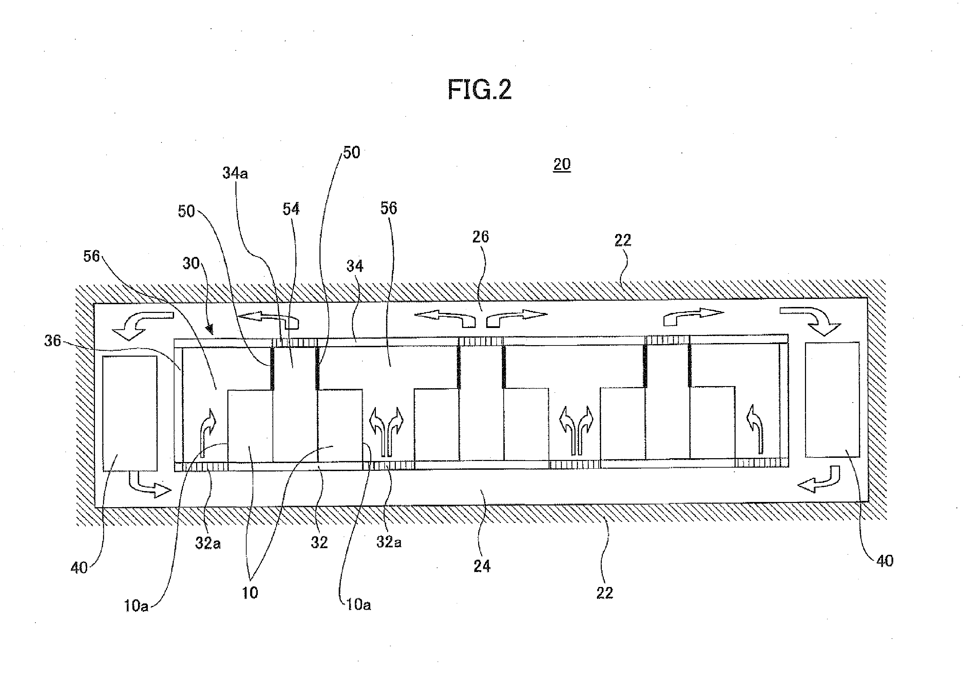

Next, an air-conditioning system according to Embodiment 1 is described. FIG. 2 schematically illustrates the inside of a data center 20 in which the air-conditioning system according to Embodiment 1 is installed.

The data center (computer room) 20 includes a space enclosed by a building material 22, such as concrete, forming a room (space) 30 enclosed by a floor 32, a ceiling 34, and side walls 36. In the room 30, a plurality of the IT apparatus mounting racks 10 are installed. Under the floor 32 of the room 30, an underfloor plenum 24 is formed in which low-temperature air flows. Above the ceiling 34 of the room 30, a ceiling plenum 26 is formed in which warmed air flows. Plural air-conditioning machines 40 are installed between the ceiling plenum 24 and the underfloor plenum 24. The air-conditioning machines 40 suction the warmed air from the ceiling plenum 24, cool the warmed air, and then send resultant low-temperature air into the underfloor plenum 24.

In the example illustrated in FIG. 2, the IT apparatus mounting racks 10 are arranged in six rows. Each of the IT apparatus mounting racks 10 extends in a direction normal to the plane of the drawing sheet of FIG. 2. Thus, FIG. 2 illustrates only the six IT apparatus mounting racks 10 at the end of the rows of the racks. The IT apparatus mounting racks 10 in the adjacent rows (such as those in the two rows to the left of FIG. 2) are disposed with their rear faces 10b opposed to each other. In the floor 32 on the side of the front face 10a of each of the IT apparatus mounting racks 10, there is provided a floor opening portion 32a configured to supply the low-temperature air from the underfloor plenum 24 into the room 30. On the other hand, in the floor 32 on the side of the rear face 10b of each of the IT apparatus mounting racks 10, no opening portion is provided. Namely, the areas on the side of the rear faces 10b of the IT apparatus mounting racks 10 do not communicate with the underfloor plenum 24.

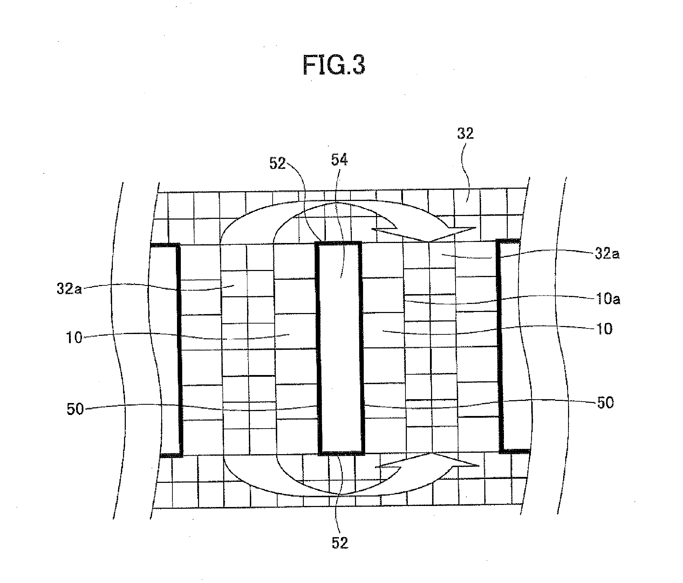

In accordance with the present embodiment, upper partitioning boards 50 are provided between the upper ends of the rear faces 10b of the IT apparatus mounting racks 10 and the ceiling 34. FIG. 3 is a plan view of a part of the room 30 as seen from the ceiling side. As illustrated in FIG. 3, the upper partitioning boards 50 are provided successively along the rows of the IT apparatus mounting racks 10. Also, end-partitioning boards 52 are provided at the ends of each of long narrow spaces defined by the upper partitioning boards 50 and the rear faces 10b of the adjacent IT apparatus mounting racks 10. Specifically, the long and narrow spaces are defined between the upper partitioning boards 50, i.e., between the rear faces 10b of the adjacent IT apparatus mounting racks 10. The long and narrow spaces are separated from the remaining internal spaces of the room 30 and are referred to as "warm-air spaces" 54.

As described above, no opening portion is provided in the floor 32 in the areas corresponding to the warm-air spaces 54, so that the warm air is not communicated to the underfloor plenum 24. On the other hand, the ceiling 34 in the areas corresponding to the warm-air spaces 54 includes ceiling opening portions 34a which connect the warm-air spaces 54 with the ceiling plenum 26.

An air-conditioning system of the data center of the above structure functions as follows.

Referring to FIG. 2, first, the air-conditioning machines 40 suction the warm air from the ceiling plenum 26, cool it, and then send the cooled, low-temperature air into the underfloor plenum 24. The low-temperature air flows out via the floor opening portions 32a in the floor 32 of the room 30 and into cool-air spaces 56 in the room 30. The cooling fans of the IT apparatuses in the IT apparatus mounting racks 10 suction the air in the cool-air spaces 56 into the IT apparatus mounting racks 10 via the front faces 10a of the IT apparatus mounting racks 10. Because only the cool-air spaces 56 in the room 30 are provided with the floor opening portions 32a, only the low-temperature air can flow out of the underfloor plenum 24 via the floor opening portions 32a and then into the cool-air spaces 56.

The low-temperature air in the cool-air spaces 56 then flows into the IT apparatus mounting racks 10 via the front opening portions 12b in the front faces 10a of the IT apparatus mounting racks 10. Thus, the low-temperature air is suctioned into the IT apparatuses 14-1 through 14-6 and power supply units 16-1 and 16-2. The low-temperature air suctioned into the IT apparatuses 14-1 through 14-6 and power supply units 16-1 and 16-2 is turned into warm air as it absorbs heat from the internal functional components. The warm air is then discharged out of the IT apparatuses 14-1 through 14-6 and power supply units 16-1 and 16-2. The warm air is then discharged out of the IT apparatus mounting racks 10 via the rack-rear-face opening portions 12c of the rear faces 10b of the IT apparatus mounting racks 10 into the warm-air spaces 54.

The warm air discharged into the warm-air spaces 54 flows into the ceiling plenum 26 via the ceiling opening portions 34a. The warm air that has entered the ceiling plenum 26 is again suctioned by the air-conditioning machines 40, turned into low-temperature air thereby, and then supplied into the underfloor plenum 24.

Thus, the air cooled by the air-conditioning machines 40 circulates through the underfloor plenum 24, the cool-air spaces 56, the inside of the IT apparatus mounting racks 10, the warm-air spaces 54, and the ceiling plenum 26. In this case, because the cool-air spaces 56 and the warm-air spaces 54 are separated from each other by the upper partitioning boards 50 and the end-partitioning boards 52, the warm air inside the warm-air spaces 54 does not easily flow into the cool-air spaces 56. Thus, only the low-temperature air can be efficiently supplied into the IT apparatus mounting racks 10.

In accordance with the present embodiment, each of the warm-air spaces 54 between the rows of the IT apparatus mounting racks 10 has its ends walled by the end-partitioning boards 52, so that the warm-air spaces 54 are individually isolated. On the other hand, as illustrated in FIG. 3, the cool-air spaces 56 include areas (spaces) on the ends of the rows of the IT apparatus mounting racks 10 in addition to the spaces along the rows. Thus, the cool-air spaces 56 form a single connected space. As a result, the following effects can be obtained.

For example, a case is considered in which the IT apparatus mounting rack 10 in one row requires more amount of cooling air (low-temperature air) than the IT apparatus mounting racks 10 in the other rows. In this case, a larger amount of cooling air needs to be supplied to the one row of the IT apparatus mounting rack 10. Because the floor opening portions 32a via which the low-temperature air flows out of the underfloor plenum 24 have substantially the same size (or area) for the various rows, it is difficult to supply a larger amount of low-temperature air from the underfloor plenum via the floor opening portions 32a to only one of the rows. Thus, a sufficient amount of low-temperature air may not be readily supplied to only one of the IT apparatus mounting racks 10 requiring a larger amount of cooling air (low-temperature air) from the underfloor plenum 24 via the floor opening portions 32a.

In accordance with the present embodiment, the cool-air space 56 in an area corresponding to the row of the IT apparatus mounting rack 10 requiring a larger amount of cooling air (low-temperature air) is connected with the cool-air spaces 56 in areas corresponding to the other rows of the IT apparatus mounting racks 10 via the areas at the ends of the rows. Therefore, as indicated by arrows illustrated in FIG. 3, the low-temperature air supplied to the cool-air space 56 in an area corresponding to the row next to the row of the IT apparatus mounting rack 10 requiring the larger amount of cooling air (low-temperature air) can flow into the cool-air space 56 in the area corresponding to the row of the IT apparatus mounting rack 10 requiring the larger amount of cooling air (low-temperature air). Thus, a sufficient amount of low-temperature air can be supplied to the row of the IT apparatus mounting rack 10 requiring a larger amount of cooling air (low-temperature air), so that an appropriate amount of low-temperature air can be supplied to each of the rows of the IT apparatus mounting racks 10.

This effect is not obtained when the cool-air spaces 56 are divided. When the low-temperature air supplied to the cool-air spaces 56 does not reach the flow rates required by the IT apparatus mounting racks 10, warm air may enter into the cool-air spaces 56 via a small gap in a separating plate, such as the upper partitioning boards 50, or a gap inside the IT apparatus mounting racks 10. As a result, the intake air temperature of the IT apparatuses may increase, resulting in a decrease in reliability of the IT apparatuses, for example.

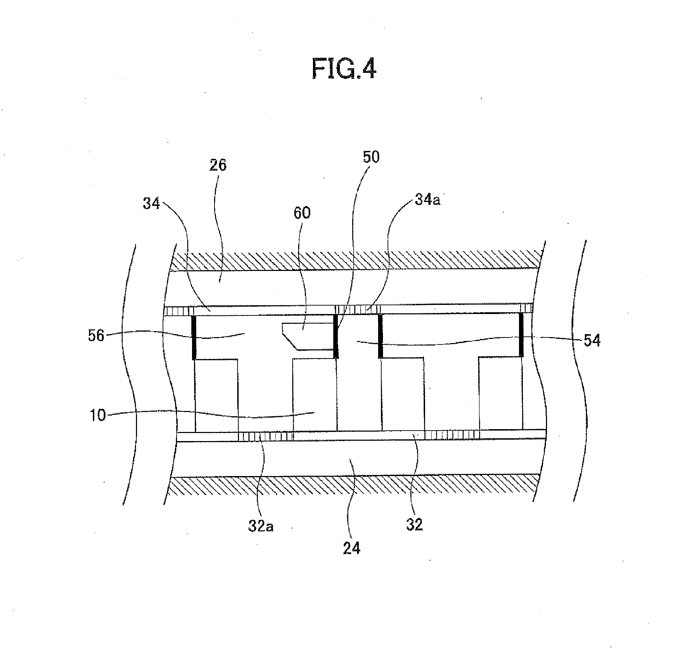

Even when the low-temperature air is shared among the rows of the IT apparatus mounting racks 10 as described above, the amount of low-temperature air to be supplied to a particular one of the IT apparatus mounting racks 10 may be lacking. In this case, a local air-conditioning machine 60 may be provided as illustrated in FIG. 4, so that cooling air can be additionally supplied only to the particular IT apparatus mounting rack 10 for which the amount of low-temperature air to be supplied is lacking.

The local air-conditioning machine 60 may be attached to the upper partitioning board 50 above the particular IT apparatus mounting rack 10 lacking in the amount of low-temperature air to be supplied. The local air-conditioning machine 60 takes in warm air from the warm-air space 54, cools the warm air, and then supplies the cooled air into the cool-air space 56. Thus, the low-temperature air can be locally supplied to the IT apparatus mounting rack 10 located below the local air-conditioning machine 60.

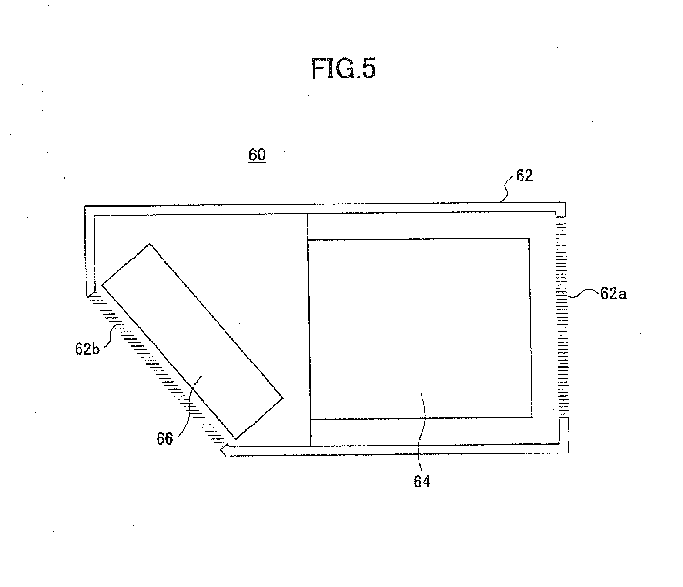

FIG. 5 illustrates a structure of the local air-conditioning machine 60. The local air-conditioning machine 60 includes a box-shaped enclosure 62 in which a heat exchanger 64 and an air blower 66 are disposed. On one side of the enclosure 62, an air inlet 62a is provided. On a side opposite to the air inlet 62a, an exhaust outlet 62b is provided. The heat exchanger 64 is disposed on the inside of the air inlet 62a. The air blower 66 is disposed on the inside of the exhaust outlet 62b.

The local air-conditioning machine 60 is disposed above the IT apparatus mounting rack 10 with the air inlet 62a opened into the warm-air space 54 and the exhaust outlet 62b positioned above the front face 10a of the IT apparatus mounting rack 10. Thus, the warm air suctioned via the air inlet 62a from the warm-air space 54 is cooled by the heat exchanger 64 and then turned into low-temperature air. The low-temperature air is passed through the air blower 66 and discharged via the exhaust outlet 62b. The low-temperature air discharged via the exhaust outlet 62b flows downward along the front face 10a of the IT apparatus mounting rack 10 located immediately below the local air-conditioning machine 60, and is supplied into the IT apparatus mounting rack 10.

Next, an air-conditioning system according to Embodiment 2 will be described.

In accordance with Embodiment 1, the upper partitioning boards 50 are provided along the rear faces 10b of the IT apparatus mounting racks 10. In accordance with Embodiment 2, the upper partitioning boards 50 are provided along the front faces 10a of IT apparatus mounting racks 10A.

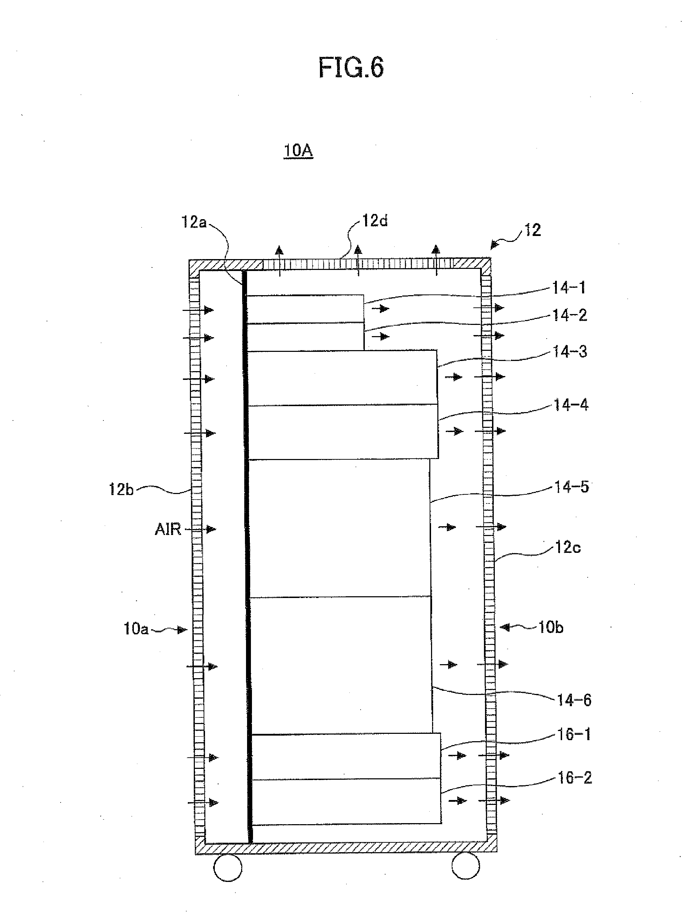

A large portion of the upper face of the IT apparatus mounting rack 10 faces the space to the rear of the intra-rack intake/discharge partitioning board 12a. Therefore, the upper face of the IT apparatus mounting rack 10 may be warmed by warm air. Thus, when the upper face of the IT apparatus mounting rack 10 is facing the cool-air space 56, the low-temperature air in the cool-air space 56 may be warmed by the increased temperature of the upper face of the IT apparatus mounting rack 10. Further, as illustrated in FIG. 6, a rack-upper-face opening portion 12d may be provided in the upper face of the IT apparatus mounting rack 10A. In this case, the warm air in the IT apparatus mounting rack 10 is also discharged via the rack-upper-face opening portion 12d.

Thus, in accordance with the present embodiment, the upper partitioning boards 50 are provided along the front faces 10a of the IT apparatus mounting racks 10A, so that the upper faces of the IT apparatus mounting racks 10A face the warm-air spaces 54.

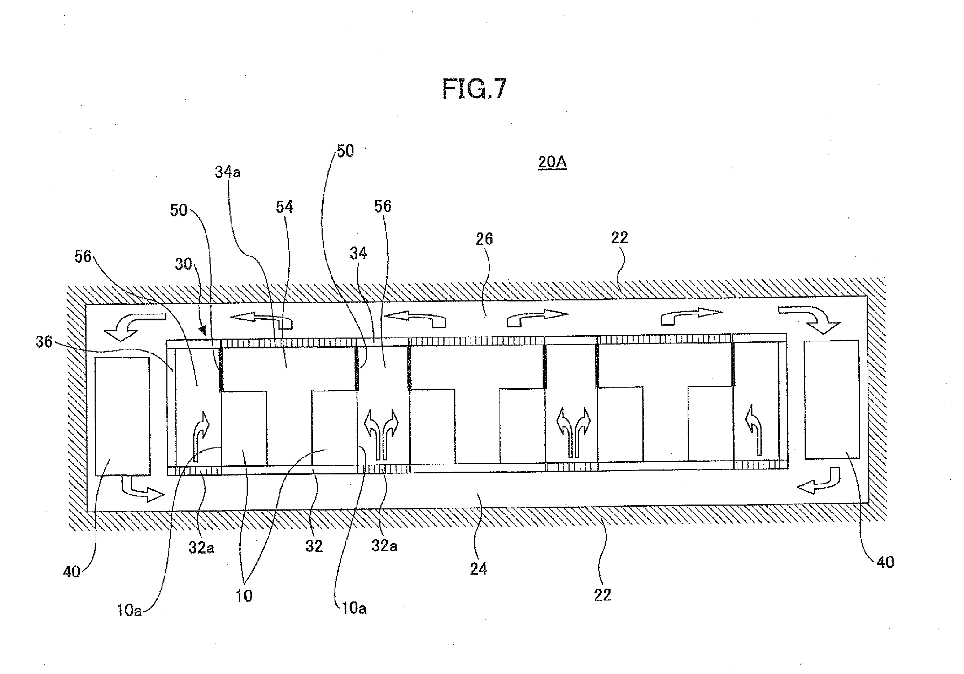

FIG. 7 illustrates an example of the inside of a data center 20A including an air-conditioning system according to Embodiment 2. In FIG. 7, parts or elements similar to those illustrated in FIG. 2 are designated with similar reference numerals in order to omit redundant description.

In accordance with the present embodiment, the upper partitioning boards 50 is provided along the front faces 10a of the IT apparatus mounting racks 10. Thus, the upper faces of the IT apparatus mounting racks 10 are facing not the cool-air spaces 56 but the warm-air spaces 54. Therefore, the low-temperature air in the cool-air spaces 56 is prevented from being warmed by the upper faces of the IT apparatus mounting racks 10. Further, as illustrated in FIG. 6, even when the rack-upper-face opening portion 12d is provided in the upper face of each of the IT apparatus mounting racks 10, as illustrated in FIG. 6, the warm air discharged via the rack-upper-face opening portion 12d flows into the warm-air spaces 54 instead of the cool-air spaces 56.

Thus, in accordance with the present embodiment, in addition to the effects provided by Embodiment 1, the cooling efficiency of the air-conditioning system is further improved by more reliably separating the warm-air spaces 54 from the cool-air spaces 56.

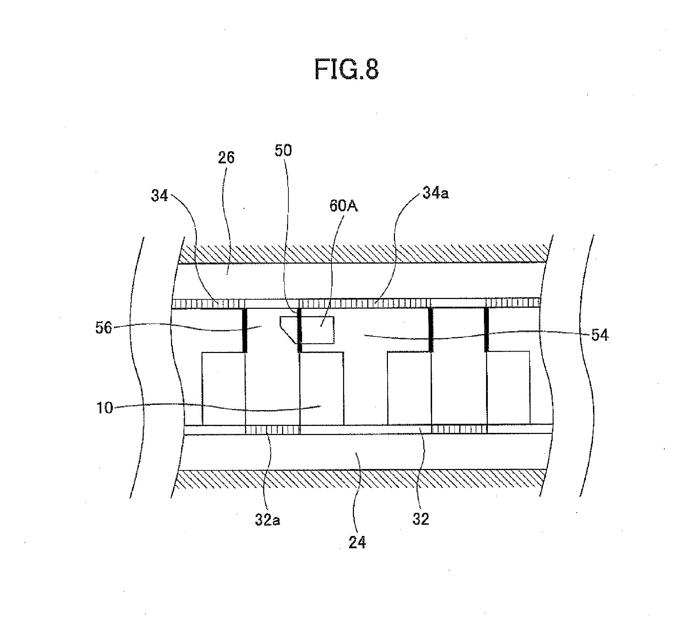

Preferably, as illustrated in FIG. 8, a local air-conditioning machine 60A may be provided to additionally provide cooling air only to the IT apparatus mounting rack 10 lacking in the amount of low-temperature air to be supplied.

The local air-conditioning machine 60A may be attached to the upper partitioning board 50 above the IT apparatus mounting rack 10 that is lacking in the amount of low-temperature air to be supplied. For example, the local air-conditioning machine 60 takes in warm air via the warm-air space 54, cools the warm air, and then supplies the cooled air into the cool-air space 56. Thus, low-temperature air can be locally supplied to the IT apparatus mounting rack 10 located below the local air-conditioning machine 60A.

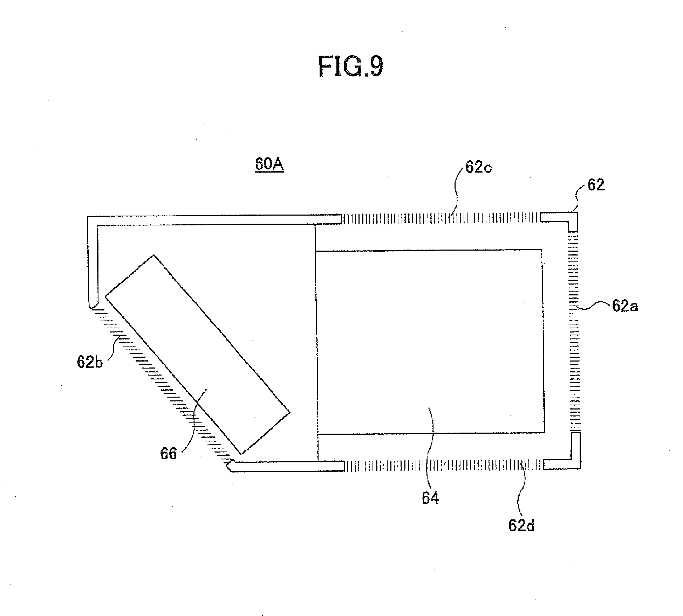

FIG. 9 illustrates a structure of the local air-conditioning machine 60A. In FIG. 9, parts or elements similar to those illustrated in FIG. 5 are designated with similar reference numerals. The local air-conditioning machine 60A includes a box-shaped enclosure 62A in which a heat exchanger 64 and an air blower 66 are disposed. On one side of the enclosure 62A, an air inlet 62a is provided. On the side opposite the air inlet 62a, an exhaust outlet 62b is provided. The heat exchanger 64 is disposed on the inside of the air inlet 62, while the air blower 66 is disposed on the inside of the exhaust outlet 62b. Further, air inlets 62c and 62d are provided in the upper face and lower face, respectively, of the enclosure 62.

The local air-conditioning machine 60A is disposed above the IT apparatus mounting rack 10 with the air inlets 62a, 62c, and 62d opened into the warm-air space 54, and with the exhaust outlet 62b positioned above the front face 10a of the IT apparatus mounting rack 10. Thus, the warm air suctioned via the air inlets 62a, 62c, and 62d into the warm-air space 54 is cooled by the heat exchanger 64 and turned into low-temperature air. The low-temperature air is then passed through the air blower 66 and discharged via the exhaust outlet 62b. The low-temperature air discharged via the exhaust outlet 62b flows downward along the front face 10a of the IT apparatus mounting rack 10 located immediately below the local air-conditioning machine 60A and then supplied into the IT apparatus mounting rack 10.

Thus, in the air-conditioning system according to an embodiment, entry of warm air in a warm-air space into a cool-air space can be prevented and only low-temperature air can be efficiently supplied into the IT apparatus mounting racks. Further, a required amount of low-temperature air can be supplied to each of plural IT apparatus mounting racks.

All examples and conditional language recited herein are intended for pedagogical purposes to aid the reader in understanding the invention and the concepts contributed by the inventors to furthering the art, and are to be construed as being without limitation to such specifically recited examples and conditions, nor does the organization of such examples in the specification relate to a showing of the superiority or inferiority of the invention. Although the embodiments of the present disclosure have been described in detail, it should be understood that various changes, substitutions, and alterations could be made hereto without departing from the spirit and scope of the invention.

## Claims

1. An air-conditioning system comprising:
a ceiling plenum disposed above a ceiling of a room;
an air-conditioning machine disposed in an internal space of the room;
a plurality of IT apparatus mounting racks disposed in a plurality of rows, with rear faces of the IT apparatus mounting racks in adjacent two rows opposed to each other;
a upper partitioning board disposed between an upper face of the plurality of IT apparatus mounting racks and the ceiling;
an end-partitioning board disposed between an end of a space between adjacent two rows of the plurality of IT apparatus mounting racks and the ceiling; and
a ceiling opening portion provided in the ceiling above a warm-air space enclosed by the upper partitioning board and the end-partitioning board,
wherein the ceiling opening portion connects the warm-air space with the ceiling plenum.

2. The air-conditioning system according to claim 1, wherein the upper partitioning board is extended along the rear face of the plurality of IT apparatus mounting racks.

3. The air-conditioning system according to claim 1, wherein the upper partitioning board is extended along a front face and an end face of the plurality of IT apparatus mounting racks.

4. The air-conditioning system according to any one of claims 1 through 3, further comprising a local air-conditioning machine including
a heat exchanger disposed above at least one of the plurality of IT apparatus mounting racks and configured to cool air in the warm-air space; and
an air blower configured to blow the cooled air out near a front face of the at least one of the plurality of IT apparatus mounting racks.

5. The air-conditioning system according to claim 1, further comprising:
an underfloor plenum disposed under a floor of the room; and
a floor opening portion provided in the floor in a cool-air space between front faces of the IT apparatus mounting racks in two adjacent rows,
the floor opening portion connecting the cool-air space with the underfloor plenum.
